# EUROPEAN PATENT APPLICATION

(11) **EP 2 369 621 A2**
(43) Date of publication of application: **28.09.2011**
(21) Application number: 10186910.5
(22) Date of filing: 07.10.2010
(51) Int. Cl.: H01L 23/544

(54) **System and method to track and authenticate semiconductor chips, multi-chip package modules and derivative system products**

(30) Priority: 23.03.2010 US 316822 P; 21.07.2010 US 841021
(71) Applicant: RFMarq, Inc., Monte Sereno CA 95030 (US)
(72) Inventor: Lin, Chang-Ming, San Jose, CA 95129 (US)
(74) Representative: Jehan, Robert

(57) **Abstract**

A method for providing identity authentication and tracking for a multi-chip package (MCP) module or a designated semiconductor chip (12) formed inside a MCP module where the MCP module is provided with a first communication function includes providing a communication element (14) formed on the MCP base where the communication element includes a memory unit for storing identification information; providing an electrical connection (16) between the communication element and the designated semiconductor chip (12); accessing by the designated semiconductor chip the information stored in the memory unit of the communication element through the electrical connection; and providing the information stored in the communication element to a system outside of the MCP module through the first communication function where the information is used at least to track or authenticate the MCP module or the designated semiconductor chip of the MCP module.

## Description

### FIELD OF THE INVENTION

The invention relates to identification devices and wired/wireless communication elements embedded in integrated circuit packages and modules.

### DESCRIPTION OF THE RELATED ART

Consumer electronic products can be tagged using electronic tracking devices or electronic tags to store product identity or other product information to allow the products to be tracked through the manufacturing process or through the supply and distribution chain. The information content of the tag may be provided by the manufacturer, the distributor, the retailer or any other entity in control of the products. Electronic tags are electronically read by electronic readers (communicators) when the tags are within range.

Radio frequency identification (RFID) technology is an electronic tracking technology commonly employed to track product identity and its movements. An RFID tag includes a transceiver device and an antenna to enable radio frequency (RF) communication between the RFID tag and an RFID reader when the reader is brought within a given range of the tag. The RFID transceiver device includes storage elements for storing identity or product information and circuitry to receive incoming signals, generate response signals and transmit the response signals.

When RFID tags are affixed to electronic products, the RFID tags are often subject to easy tampering. For example, if the RFID tag is merely placed on the chassis or even on internal printed circuit board of an electronic product, the RFID tag can be removed to prevent tracking of the product. Furthermore, when RFID tags are used, the RFID reader must be brought within a certain range of the RFID tags in order to communicate with the tags to obtain tag content or to update tag content.

### SUMMARY OF THE INVENTION

According to one embodiment of the present invention, a method for providing identity authentication for a multi-chip package (MCP) module or a designated semiconductor chip selected from one or more semiconductor chips formed in an MCP base of the MCP module, where the MCP module is provided with a first communication function which includes providing a communication element formed on the MCP base where the communication element includes a memory unit for storing information including at least identity information of the designated semiconductor chip or the MCP module; providing an electrical connection between the communication element and the designated semiconductor chip; accessing by the designated semiconductor chip the information stored in the memory unit of the communication element through the electrical connection; and providing the information stored in the communication element to a system outside of the MCP module through the first communication function of the MCP module where the information is used at least to track or authenticate the MCP module or the designated semiconductor chip of the MCP module.

According to another aspect of the present invention, a method for providing identity tracking and authentication for a multi-chip package (MCP) module or a designated semiconductor chip selected from one or more semiconductor chips formed on an MCP base of the MCP module where the MCP module is provided with a first communication function includes providing a wireless communication element formed on the MCP base, the wireless communication element including a memory unit for storing information including at least identity information of the designated semiconductor chip or the MCP module and including a wireless communication circuit; providing a wireless communication transceiver formed on the MCP base and in communication with the designated semiconductor chip where the wireless communication transceiver provides a second communication function; accessing by the wireless communication transceiver the information stored in the memory unit of the wireless communication element through the second communication function; and providing the information stored in the communication element to a system outside of the MCP module through the first communication function of the MCP module where the information is used at least to track or authenticate the MCP module or the designated semiconductor chip of the MCP module

According to another aspect of the present invention, a multi-chip package (MCP) module including one or more semiconductor chips formed on an MCP base of the MCP module where the MCP module is provided with a first communication function includes a communication element formed on the MCP base, the communication element including a memory unit for storing information including at least identity information of the designated semiconductor chip or the MCP module; and an electrical connection between the communication element and a designated semiconductor chip selected from the one or more semiconductor chips formed on an MCP base of the MCP module. The designated semiconductor chip accesses the information stored in the memory unit of the communication element through the electrical connection, and provides the information stored in the communication element to a system outside of the MCP module through the first communication function of the MCP module, the information being used at least to track or authenticate the MCP module or the designated semiconductor chip of the MCP module.

### BRIEF DESCRIPTION OF THE DRAWINGS

Embodiments of the present invention are described below, by way of example only, with reference to the accompanying drawings, in which:

Fig. 1 is a schematic diagram of a MCP base for implementing the track and authenticate system and method according to a first embodiment of the present invention.

Fig. 2 is a schematic diagram of a MCP base for implementing the track and authenticate system and method according to a second embodiment of the present invention.

Fig. 3 is a schematic diagram of a MCP base for implementing the track and authenticate system and method according to a third embodiment of the present invention.

Fig. 4 is a schematic diagram illustrating an MCP module incorporating the MCP base of Fig. 1 and also illustrating an alternate antenna structure according to a fourth embodiment of the present invention.

Fig. 5 is a schematic diagram illustrating an MCP module incorporating the MCP base of Fig. 2 and also illustrating an alternate antenna structure according to a fifth embodiment of the present invention.

Fig. 6 is a schematic diagram illustrating an MCP module according to a sixth embodiment of the present invention.

Fig. 7 is a schematic diagram of a MCP base for implementing the track and authenticate system and method according to a seventh embodiment of the present invention.

Fig. 8 is a schematic diagram of a MCP base for implementing the track and authenticate system and method according to an eighth embodiment of the present invention.

Fig. 9 illustrates an operating environment in which the remote verification system and method of the present invention operation according to one embodiment of the present invention.

### DETAILED DESCRIPTION OF THE PREFERRED EMBODIMENTS

According to one embodiment of the present invention, systems and methods for tracking or authenticating a microelectronic device, and/or a derivative system product incorporating the microelectronic device, incorporate a wireless communication element in the packaging of the microelectronic device to allow identity or other identification information for the microelectronic device, and/or the derivative system product incorporating the microelectronic device, to be authenticated or tracked locally or remotely. In embodiments of the present invention, the microelectronic device includes one or more integrated circuits formed in a multi-chip package (MCP) module and the wireless communication element is formed as part of the MCP module. The identity information stored in the wireless communication element may be accessed directly from the wireless communication element or the information may be accessed through the communication function of the microelectronic device. In this manner, the identity or identification information for the microelectronic device and its derivative system product can be verified or authenticated locally or remotely to ensure the authenticity of the microelectronic device and/or the derivative system product. Furthermore, the physical location of the microelectronic device and /or the derivative system product can be tracked using the stored identity or identification information. Furthermore, by embedding the wireless communication element in the MCP module of the microelectronic device, the wireless communication element is protected from tampering, further ensuring the authenticity of the microelectronic device and/or its derivative system product.

The advantages provided by the track and authenticate system and method of the preferred embodiments of the present invention are numerous. The systems and methods of the preferred embodiments enable verification of the authenticity of an integrated circuit (IC) chip (also referred to as a semiconductor chip), or a chipset, or a microelectronic device or an electronic system product, or the original equipment manufacturer (OEM) of the IC chip or microelectronic device or the OEM of the system product embodying the IC chip or microelectronic device. The systems and methods may also store and track the production and/or distribution history of the MCP module or the designated semiconductor chip, the original owner of the microelectronic device or system. For instance, in accordance with the preferred embodiments, the identity information of a pre-selected key IC in a microelectronic device is stored in the wireless communication element and the authenticity of the microelectronic device or its derivative system products, ranging from a multi-chip package, including the selected key IC chip itself, to an electronic system product incorporating the microelectronic device, can be verified remotely and independent of the function and operation of the microelectronic device. Remote identity verification and location tracking can be performed expediently and accurately. The track and authenticate systems and methods of the preferred embodiments ensure tamper-resistant to provide added security.

In the present description, a "multi-chip package" or "MCP" refers to a packaging configuration containing two or more integrated circuit (IC) chips or die housed in a semiconductor package, most often a standard single-chip package, so that the MCP appears as if all of the IC chips of the MCP were integrated and packaged as a single die. In some cases, the IC chips are electrically connected to a multilayer interconnect substrate with interconnects between the IC chips formed thereon. The multilayer interconnect substrate can be formed as a laminate, such as a printed circuit board, or formed using ceramic or silicon. The IC chips can be connected to the multilayer interconnect substrate through wire bonding or through flip-chip bonding or solder bump or gold bump or conductive adhesive bonding to preformed bonding pads on the multilayer interconnect substrate. In other cases, the IC chips are attached to a die paddle with inter-die connections formed through wire bonding. The IC chips may be attached to a single die paddle or to a "split pad" die paddle with separate die pads for the individual IC chips. In the present description, the die paddle and the multilayer interconnect substrate on which the IC chips are attached are collectively referred to as a "MCP base."

The MCP may be protected by an encapsulant or left unencapsulated. When encapsulated, the encapsulant can be a polymer molding compound or equivalent polymers. The MCP can be formed using a ceramic package body, a plastic package body, or a metal package body. In the present description, the "MCP package body" refers to the housing in which the MCP base, the lead frame or bonding pads, and the external leads (balls or pins) are formed.

When the MCP base is a multilayer interconnect substrate, the dies are electrically connected to the metal interconnects formed in the MCP base which realize high density die-to-die routing. The IC chips can be electrically connected to the MCP base through wire bonding or through flip-chip bonding or solder bump or gold bump or conductive adhesive bonding to preformed bonding pads on the MCP base. In some cases, for extremely simple MCP configuration, the die-to-die routing can be implemented inside the MCP package body using bond wires instead of using a multilayer interconnect substrate.

An MCP operates as if all the chips were integrated into one single die and packaged as such, since the same form factor and footprint are kept to facilitate subsequent board assembly operations. Thus, MCP provides package-level integration that is transparent to the end-user who only sees the end product as one single package. MCPs can also incorporate the use of passive components. The finished form of an MCP is often referred to as an "MCP module" and can be in a variety of package forms, such as plastic quad flat packages (PQFP) or plastic ball grid array (BGA) multi-chip packages, or ceramic BGA packages or chip-on-board (COB) multi-chip packages or other appropriate semiconductor package forms. In the present description, an "MCP" or an "MCP module" refers to the encapsulated or unencapsulated IC package housing an MCP base and including two or more integrated circuit chips formed thereon where the integrated circuit chips may or may not be electrically interconnected.

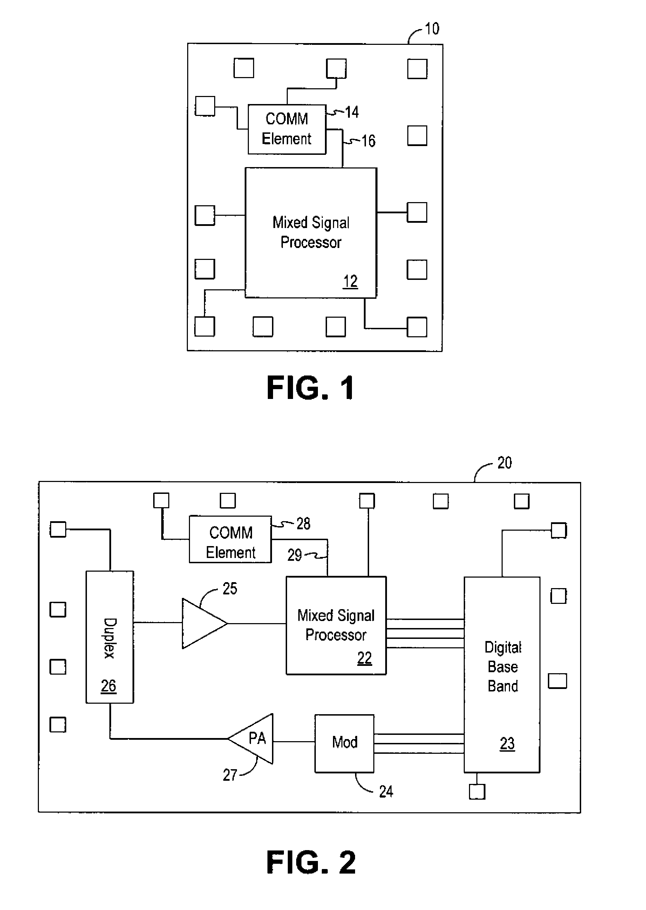

Fig. 1 is a schematic diagram of a MCP base for implementing the track and authenticate system and method according to a first embodiment of the present invention. Referring to Fig. 1, an MCP base 10 includes a multilayer interconnect substrate (an MCP substrate) on which an integrated circuit (IC) chip 12 is attached. In the present embodiment, IC chip 12 is a mixed signal processor chip and is flip-chip bonded to MCP base 10. IC chip 12 has input/output (I/O) pads connected to the I/O pads of MCP base 10 through metal interconnects of the multilayer interconnect substrate as shown or through wire bonding in an alternate embodiment. To implement the track and authenticate system and method of the preferred embodiments, a wireless communication element 14 is also formed on MCP base 10. Wireless communication element 14 may also have I/O pads connected to the I/O pads of MCP base 10 through the multilayer interconnect substrate as shown or through wire bonding in an alternate embodiment. Wireless communication element 14 includes circuitry for facilitating wired or wireless communication or other wireless functions and also a memory unit for storing identity or identification information of IC chip 12. In some embodiments, wireless communication element 14 includes a GPS (global positioning system) functional block. MCP base 10 is incorporated with a lead frame or bonding pads, a package body and optional encapsulant to form an MCP module.

In the present description, "identity" or "identification information" of an IC chip includes the identification number, part number, model number, model name, brand name, maker, logo design, and production and/or distribution history of the IC chip and/or the MCP module to be formed. Furthermore, identity or identification information can include a software code or an algorithm to generate an identity code in response to interrogations from certain IC chip(s) formed in the same MCP module or from a system to which the MCP module is to be connected. In embodiments of the present invention, the data format of the identification information includes a random or serial numerical numbers or characters, logo marks, graphic symbols, 2D graphic codes, or any multiplex permutation of these formats. Other encoding or algorithms methods currently known or to be developed can also be used. In another embodiment, the track and authenticate system and method of the present invention protect the identity or identification information stored in the wireless communication element through the use of encryption or software keys or other feasible security protection methods presently known or to be developed.

Also, in the present embodiment, the wireless communication element is capable of wireless communication employing one or more of the wireless communication technologies currently known or to be developed. For example, in one embodiment, the wireless communication element implements wireless communication through radio frequency (RF) communication, such as based on the RFID (radio frequency identification) technology, or wireless local area network communication technology, such as Wi-Fi technology. In another embodiment, the wireless communication element employs Bluetooth radio technology. Bluetooth radio technology is an open specification for short-range wireless communication of data and voice that operates in the unlicensed Industrial, Scientific, Medical (ISM) band at 2.4 Gigahertz (GHz). The gross data rate may be 1 megabit per second (Mb/s). In yet another embodiment, the wireless communication element employs ZigBee communication technology. ZigBee is a wireless control technology utilizing a low-cost, low power, wireless mesh networking protocol that is especially useful in control and monitoring applications. In yet another embodiment, the wireless communication element employs WiMAX communication. Furthermore, in the present embodiment, the wireless communication element is also capable of wired communication through the IC chips of the MCP module to be formed, as will be described in more detail below.

Forming wireless communication element 14 on the same MCP base as IC chip 12 has the unique advantage of providing communication between the two components through metal interconnects formed on or in the multilayer interconnect substrate. In the present embodiment, a metal line 16 provides die-to-die interconnection between IC chip 12 and wireless communication element 14. More specifically, metal line 16 provides two-way communication between wireless communication element 14 and IC chip 12. In other embodiments, metal line 16 may be implemented as a metal bus including multiple parallel metal lines. By providing die-to-die interconnection 16, information stored in wireless communication element 14 can be read out by IC chip 12 and communicated to systems outside of the MCP module through the communication function of IC chip 12. For instance, when IC chip 12 is capable of wireless or wired communication, IC chip 12 can operate to retrieve the identification information stored in wireless communication element 14 and communicate the information to a system external to the MCP module to be formed from the MCP substrate 10 through the communication function of the IC chip 12 or the communication function of the MCP module. Furthermore, IC chip 12 can also cause information to be stored in wireless communication element 14 through metal line 16.

Fig. 2 is a schematic diagram of a MCP base for implementing the track and authenticate system and method according to a second embodiment of the present invention. Referring to Fig. 2, an MCP base 20 includes a multilayer interconnect substrate (an MCP substrate) on which multiple IC chips 22-27 are attached. In the present illustration, the multiple IC chips include a mixed signal processor, a duplexer, a modulator, a digital base band processor and a power amplifier to form a digital mixed-signal processing module. The IC chips 22-27 are interconnected through metal lines formed in the multilayer interconnect substrate of the MCP base 20. MCP base or MCP substrate 20 is incorporated with a lead frame or bonding pads, a package body and optional encapsulant to form an MCP module. The interconnected IC chips formed on the MCP base operate as a unit to devices and systems outside of the MCP module so that the number of individual IC chips becomes transparent to users utilizing the MCP module thus formed.

To implement the track and authenticate system and method of the preferred embodiments, a wireless communication element 28 is formed on MCP base 20. Wireless communication element 28 may have I/O pads connected to the I/O pads of MCP base 20 by flip-chip attachment method through the multilayer circuit board as shown or through wire bonding in an alternate embodiment. Wireless communication element 28 includes circuitry for facilitating wired or wireless communication or other wireless functions and also a memory unit for storing identity or identification information of one or more IC chips 22-27. In one embodiment, one of the multiple IC chips 22-27, such as IC chip 22, is selected as the designated IC chip or designated semiconductor chip and wireless communication element 28 stores identification information relating to the designated IC chip. Wireless communication element 28 may also store identification information relating to the MCP module to be formed.

In the present embodiment, a metal line 29 provides die-to-die interconnection between designated IC chip 22 and wireless communication element 28. Information stored in wireless communication element 28 can be read out by IC chip 22 through interconnect wire 29 and communicated to systems outside of the MCP module to be formed through the communication function of IC chip 22 or the communication function incorporated in the MCP module. For instance, when IC chip 22 is capable of wireless or wired communication, or when the MCP module formed by IC chips 22-27 is capable of wireless or wired communication, IC chip 22 can operate to retrieve the identification information stored in wireless communication element 28 and communicate the information to a system external to the MCP module thus formed through the communication function of the IC chip 22 or the MCP module.

In one embodiment, the multilayer interconnect substrate is pre-fabricated by use of thin film process technology or fine pitch PCB (printed circuit board) process or equivalent processing technologies. In other embodiments, the MCP base can be formed using a silicon substrate or fine pitch PCB substrate or ceramic substrate or other thin film process compatible substrate materials. Electrical conductive substrate can be used but must be insulated prior to the construction of the interconnect structure. The multilayer interconnects can be built by forming alternating metal layers and insulating dielectric layers. The metal layers can be defined by metal trace lithography masking, metal etch. Interconnection channel between different metal layers can be constructed through dielectric layers via photoresist masking and dielectric etch, followed by metal layer deposition using thin film metallization deposition process.

In one embodiment, the metal line providing die-to-die interconnection between the wireless communication element and the IC chip (metal line 16 or 29) is part of the preformed interconnect structure of the MCP base. In other embodiments, the die-to-die connection is realized using wire bonds, or using solder bump connection or gold bump connection, or using conductive silver paste or ink, or other conductive pastes, or a flexible connector with solder bumps (or balls) for joining the interconnections. Other methods to be developed for providing the electrical connection between two integrated circuit components can also be used.

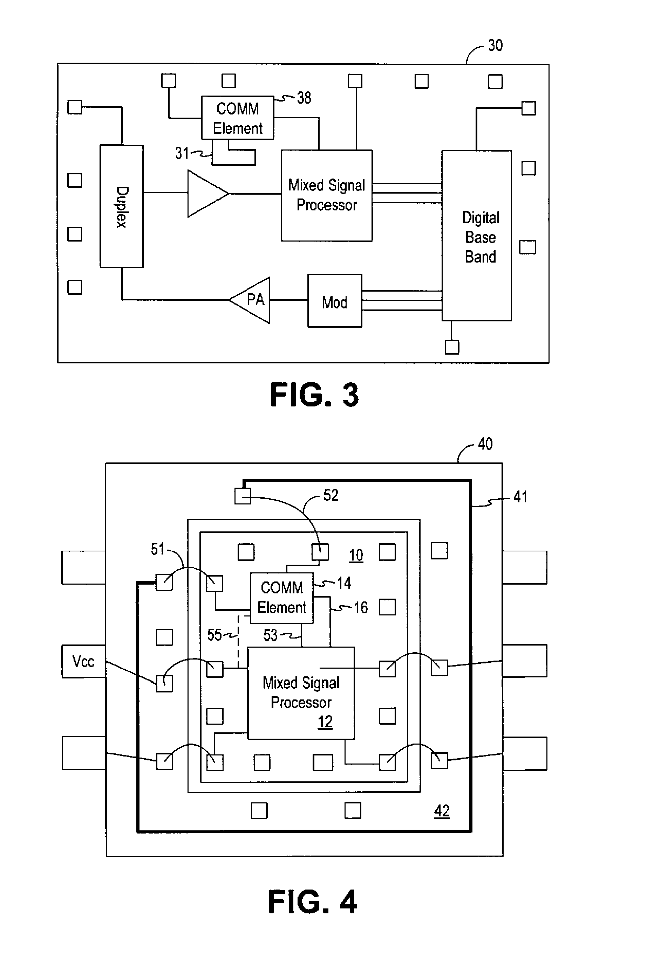

In one embodiment of the present invention, the track and authenticate system and method exploit the multilayer interconnect structure of the MCP base to form the antenna for the wireless communication element. Fig. 3 is a schematic diagram of a MCP base for implementing the track and authenticate system and method according to a third embodiment of the present invention. Referring to Fig. 3, an MCP base 30 is constructed in the same manner as MCP base 20 of Fig. 2 and similar elements will not be further described. MCP base 30 is constructed as a multilayer interconnect substrate and thus is also referred to as MCP substrate 30. MCP substrate 30 is incorporated with a lead frame or bonding pads, a package body and optional encapsulant to form an MCP module.

In MCP substrate 30, an antenna structure 31 for a wireless communication element 38 is formed either on or in the multilayer interconnect substrate so that the antenna structure is formed in the available real estate of the MCP substrate. The same type of antenna structure can also be formed on or in the MCP substrate 10 of Fig. 1. The antenna can be formed using one metal layer or using multiple metal layers of the multilayer interconnect substrate. In this manner, the wireless communication element 38 including antenna 31 is formed in the MCP substrate without altering or increasing the size of the MCP module to be formed. In other words, the wireless communication element and its associated antenna can be embedded inside an MCP module without altering the original structure of the MCP module and the incorporation of the wireless communication element becomes invisible to end users of the MCP module. By forming the antenna using one or more metal layers of the MCP substrate, a desired antenna size can be realized within the MCP module. With antenna structure 31 provided, the identification information stored in the wireless communication element 38 can also be directly operated or retrieved by a wireless reader within its signal working range.

Fig. 4 is a schematic diagram illustrating an MCP module incorporating the MCP base of Fig. 1 and also illustrating an alternate antenna structure according to a fourth embodiment of the present invention. Referring to Fig. 4, in the present embodiment, the MCP base 10 is packaged in a dual-in-line (DIP) package and may be encapsulated or covered with a lid to form the MCP module 40. In other embodiments, the MCP base can be packaged in other semiconductor packages, including ceramic, metal or plastic packages. The bonding pads on the MCP base 10 are connected to bonding pads or lead fingers formed on the package body 42 of the MCP module 40 using bond wires. In MCP module 40, an antenna structure 41 is formed inside the package body 42 of MCP module 40 and connected to wireless communication element 14 through bond wires 51 and 52. In other embodiments, the antenna structure 41 is connected to the wireless communication element 14 through an electrical connection formed by solder bumps or conductive adhesives. MCP module 40 illustrates another method for forming an antenna for the wireless communication element that can be integrated into the structure of the MCP module so that no additional antenna components are required to realize the track and authenticate method and system. In other embodiments, the antenna structure can be prefabricated as an independent unit of metal foil or a surface mount unit with a rigid or flexible non-conductive substrate support. The prefabricated antenna structure can then be attached to I/O pads of the MCP module to be connected to the wireless communication element. Alternately, the antenna structure 41 can be formed on and electrically insulated from the lead frame of the MCP module.

In some embodiments, wireless communication element 14 in MCP module 40 is flip-chip attached to the MCP base 10 by solder bump joints and physically interconnected with main IC processor chip via interconnect 16 formed on MCP base 10. Wireless communication element 14 can be powered through IC chip 12 via metal interconnects (such as metal line 53) formed on MCP base 10. Alternately, both the wireless communication element and the IC chip 12 can share the same power supply input (Vcc) from the external package pin through independent interconnect traces formed on the MCP base, such as dotted line 55 in Fig.4. In yet another alternate embodiment, wireless communication element 14 is powered independently by a power supply (Vcc) from a separate external package pin.

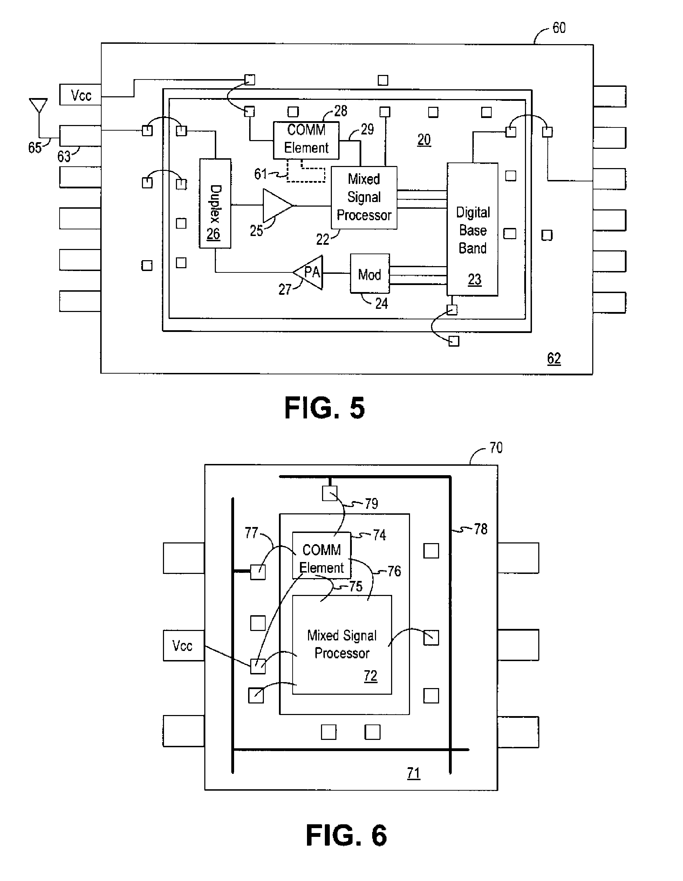

Fig. 5 is a schematic diagram illustrating an MCP module incorporating the MCP base of Fig. 2 and also illustrating an alternate antenna structure according to a fifth embodiment of the present invention. Referring to Fig. 5, in the present embodiment, the MCP base 20 is packaged in a dual-in-line (DIP) package and encapsulated or covered with a lid to form the MCP module 60. In other embodiments, the MCP base 20 can be packaged in other semiconductor packages. The bonding pads on the MCP base 20 are connected to bonding pads or lead fingers on the package 62 of the MCP module 60 using bond wires. In MCP module 60, an antenna structure 61 is formed on the MCP base, as shown in Fig. 5. Interrogation of wireless communication element 28 is thus made possible through antenna 61 and the wireless communication function of the wireless communication element 28. Alternately, wireless communication element 28 can be interrogated by the IC chips 22-27 of the MCP module 60 and the stored information being provided through the communication function of the MCP module 60. In the present illustration, MCP module 60 is capable of wireless communication and a package pin 63 is to be connected to an antenna external to the MCP module. In that case, indentifying information stored in wireless communication element 28 can be retrieved by designated IC chip 22 through wire 29 and provided to systems external to MCP module 60 through duplexer 26 and antenna 65.

By co-locating the wireless communication element with the IC chips of an MCP module, the wireless communication element can receive the same power supplied to the IC chips of the MCP module. Accordingly, the wireless communication element can be an active device, powered by the power supply of the MCP module, or a passive device, powered by the interrogating device.

The track and authenticate system and method can be applied to MCP modules formed using one or more IC chips. When only a single IC chip is included in the MCP module, the wireless communication element becomes the second IC chip, thereby forming the multi-chip package. In that case, the single IC chip and the wireless communication element may be affixed to a die paddle instead of a multilayer interconnect substrate, as shown in Fig. 6. Referring to Fig. 6, the package used to house the IC chip 72 only needs to have sufficient I/O population or I/O design to accommodate IC chip 72. The IC chip 72 and a wireless communication element are attached to the die paddle using a die attach. A wire bond 76 is used to realize the die-to-die connection between wireless communication element 74 and IC chip 72. Additionally, power can be optionally supplied to the wireless communication element 74, such as through a bond wire connection 75. The antenna 78 for wireless communication element 74 is formed in the package body 71 or on and electrically insulated from the lead frame and is electrically connected to the wireless communication element through bond wires 77, 79. Depending on the final package type used, wireless communication element 74 and IC chip 72 can also be flip-chip attached to the package substrate.

In some embodiments, the wireless communication element is an RFID chip and the RFID chip coupled with an antenna forms an RFID tag capable of communicating wirelessly using radio frequency with an RFID reader. The RFID reader retrieves the stored information in the RFID tag and may transmit the retrieved information over a wired or wireless network.

In some embodiments, the antenna for the RFID chip is fabricated simultaneously with the construction of the MCP package, such as by forming the antenna in the package body or on and electrically insulated from the lead frame as shown in Fig. 4 and Fig. 6. The antenna can be connected to the wireless communication element through wire bonding from the antenna bonding pads on the MCP package body to bonding pads formed on the MCP base, as shown in Fig. 4. The antenna can also be connected to the wireless communication element through wire bonding to contact pads formed on the wireless communication element, as shown in Fig. 6. The antenna connection can also be completed using flexible connector with solder or gold bump or conductive adhesive joints.

In the above-described embodiments, the MCP module is shown incorporating a mixed signal processor chip. The embodiments described above are illustrative only and are not intended to be limiting. In fact, the MCP module may include any types of integrated circuit chips performing any functions. For instance, in other embodiments, the MCP module may be configured as an electronic module, as an electro-optic module, an electro-mechanical module or an electro-chemical module, or any combination thereof. Typical MCP modules are used to incorporate microprocessor chip set, graphic chip set, wireless communication chip set, chemical sensor module, gas sensor module, image sensor module, or power regulation module.

The track and authenticate system and method of the preferred embodiments provide many advantages in operation. First, the system and method of the preferred embodiments enable chip-level tracking of manufacturing or distribution of a microelectronic device, an electronic sub-system or system product, an electronic system or tool or equipment incorporating an MCP module provided with the wireless communication element. Second, a final system product embedded with the wireless communication element in one of the MCP microelectronic device becomes traceable throughout the system product's life cycle. The traceability ensures that reliable e-waste management is feasible. Third, the track and authenticate system and method of the preferred embodiments enable the tracing and tracking of recycled semiconductor packages or MCP modules or sub-systems or systems. Fourth, since the wireless communication element is embedded in the MCP module, tamper resistance is inherent. A tamper-resistance tracking device would deter or eliminate counterfeit or other illegal invasions, such as illegal access of protected or proprietary service or communication systems. Lastly, the identification information can be used by wired or wireless communication networks through the MCP module to authenticate and locate geographic location of the MCP module or the system product incorporated with the MCP module. The taught system and method can also provide numerous other benefits and advantages not described herein. For instance, the taught system and method can be applied to help in tracing and tracking of lost or misplaced expensive mobile tech gadgets.

According to embodiment, the wireless communication element embedded in the MCP module in the above-described embodiments is configured as a memory only identification (Pure ID) element without including communication circuitry and without being coupled to an antenna. The Pure ID element, also referred to as "a communication element," is electrically interconnected with the designated IC chip on the MCP module to allow the designated IC chip to access the store identification information. The die-to-die interconnection can be achieved using any one of the connection methods described above, including metal interconnects formed in the multilayer interconnect substrate or the package body, with solder bonds or with wire bonds. The stored identification information can be secured using the security method described above, such as encryption or by using an algorithm to generate identification information on-the-fly upon interrogation. As thus configured, the identification information is transported or communicated only through the wired or wireless communication function of the system product containing the MCP module embedded with the Pure ID element. Through the communication function of the system product containing the MCP module, the stored identification information of Pure ID element can be provided to networks connected with the system product containing the MCP module.

For example, in some embodiments, the MCP module may be incorporated in a mobile telephone. The stored identification information of the wireless communication element or a Pure ID element may be retrieved by the signal processing chip of the mobile telephone and communicated to a wireless network through the wireless communication capability of the mobile telephone. When the wireless communication element is equipped with its own antenna, the stored identification information can also be retrieved by wireless communication directly with the wireless communication element, such as through the use of a wireless reader device.

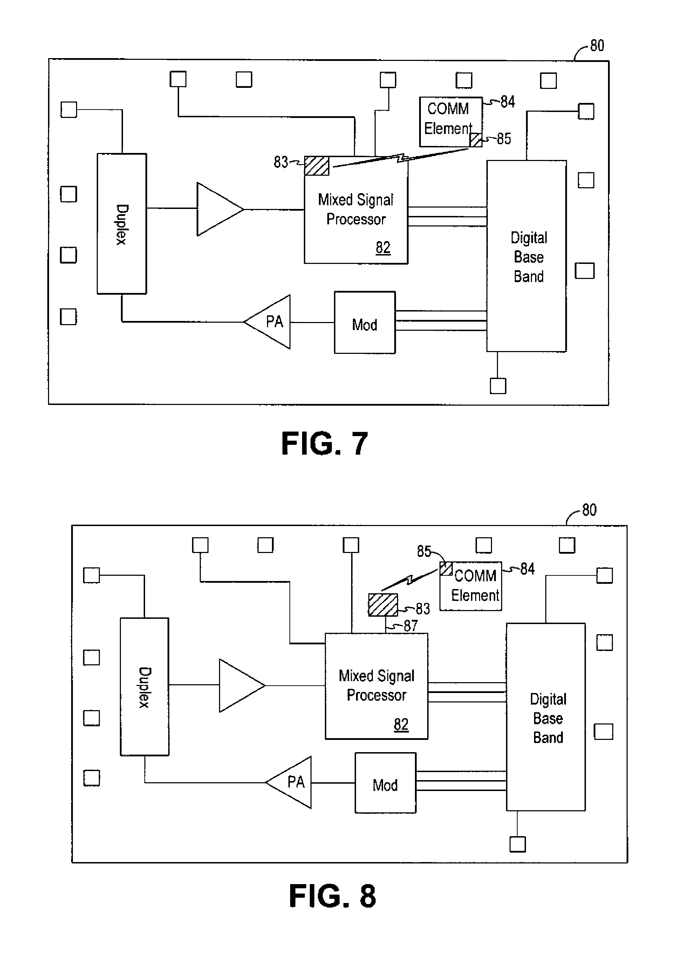

According to yet another embodiment, the wireless communication element embedded in the MCP module in the above-described embodiments is configured to communicate wirelessly with a wireless transceiver formed on the MCP base. Fig. 7 is a schematic diagram of a MCP base for implementing the track and authenticate system and method according to a seventh embodiment of the present invention. Referring to Fig. 7, an MCP base or an MCP substrate 80 includes an IC chip 82 and a wireless communication element 84 attached thereon. In the present embodiment, wireless communication element 84 incorporates a transceiver 85 while IC chip 82 incorporates a transceiver 83. The IC chip 82 is then able to communicate with the wireless communication element 84 through transceivers 83, 85, such as by means of software program control or hardware design. In an alternate embodiment, the transceiver 83 may be a standalone component on the MCP substrate and not incorporated in IC chip 82, as shown in Fig. 8. Transceiver 83 communicates wirelessly with transceiver 85 of wireless communication element 84 and provides the retrieved information to IC chip 82 through an interconnect line 87 formed on the MCP base.

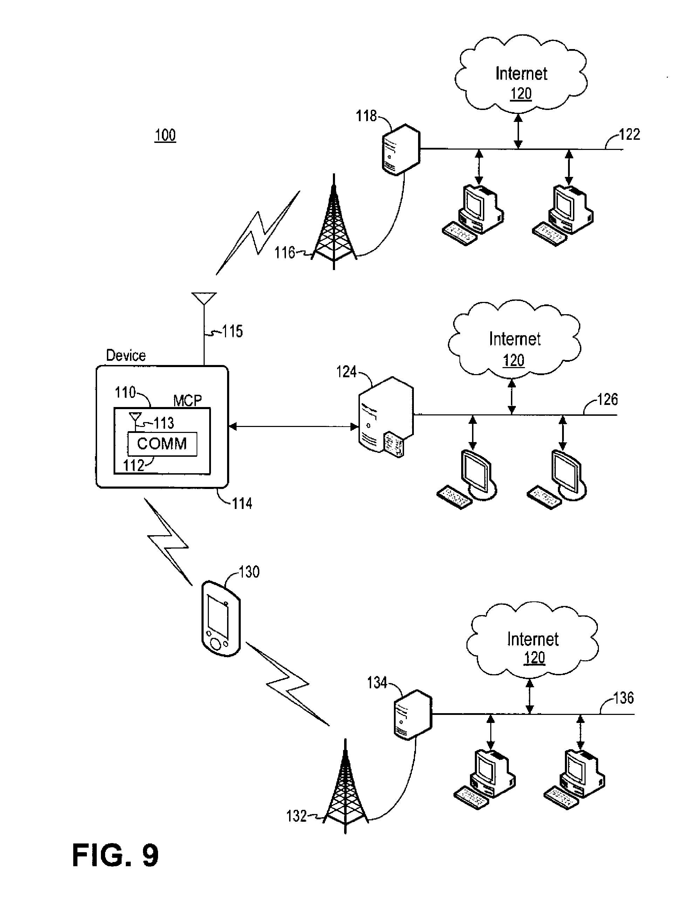

When an MCP module is configured to implement the taught track and authenticate system and method, the MCP module or associated device and system may be authenticated using the information stored in the wireless communication element or the Pure ID element. Fig. 9 illustrates an operating environment in which the track and authenticate system and method operate according to one embodiment of the present invention. Referring to Fig. 9, an MCP module 110 incorporating a wireless communication element 112 is embedded in an electronic device 114. In the present illustration, electronic device 114 is capable of wireless communication through its own antenna 115. Also, in the present illustration, wireless communication element 112 is provided with an antenna 113 to allow element 112 to communicate wirelessly. Alternately, wireless communication element 112 may be configured as a Pure ID element without any associated antenna. The Pure ID element is accessed by other IC chips formed on the MCP module 110 to retrieve the stored identification information. In one exemplary embodiment, electronic device 114 is a mobile telephone and MCP module 110 contains the signal processing and communication chip sets of the mobile telephone. In other embodiments, electronic device 114 may be a microelectronic device incorporated in a laptop computer, a personal digital assistant, a personal computer, a Netbook, a hand computer, a superior thin hand computer, a smart mobile phone, an ebook reader, an Intelligent smart card, HDTV or LCD TV, or an automobile, or a vessel, or an aircraft, or a manufacturing processing equipment, or a weapon or a weapon system.

In one embodiment, the stored identification information in wireless communication element 112 is accessed by the IC chips of the MCP module 110 and the retrieved information is communicated wirelessly from antenna 115 of electronic device 114 to a wireless network, such as through base station 116. From base station 116, the information can be passed to a computer network 122 through a server 118. From computer network 122, the retrieved identification information may also be passed to the Internet to other gateways or networks connected to the Internet.

In another embodiment, the stored identification information in wireless communication element 112 is accessed by the IC chips of the MCP module 110 and is communicated through a wired connection to a computer network 126 through a server 124. From computer network 126, the retrieved information may also be passed to other gateways or networks.

When wireless communication element 112 is configured as a Pure ID element, the stored identification information is retrieved using one of the above-described methods where the IC chips of the MCP module 110 retrieves the stored information from the Pure ID element and the communication function of the MCP module 110 is used to transport or communicate the retrieved information to computer networks or the Internet outside of electronic device 115.

In the case where wireless communication element 112 is provided with an antenna 113, the stored identification information in wireless communication element 112 may be accessed directly by a wireless reader device 130. Wireless reader device 130 communicates wirelessly with wireless communication element 112 to retrieve the stored identification information. Wireless reader device 130 may be provided with communication capability with a wireless network, such as through base station 132. From base station 132, the retrieved information can be passed to a computer network 136 through a server 134. From computer network 136, the retrieved identification information may also be passed to the Internet to other gateways or networks connected to the Internet.

In some embodiments, the wireless reader device provides instructions to the wireless communication element through wireless communication. The instruction may include at least a read command, a write command, a lock command or a kill command.

Furthermore, in some embodiments, the memory unit of the Pure ID element or the wireless communication element is configured with a write protect function where the memory unit is accessible only through secured interrogation or secured authentication procedures. The secured interrogation or authentication procedures can include using password or security key, or RSA security algorithms or other cryptography protection methods.

The computer networks 122, 126, 136 shown in Fig. 9 can be a physical network such as a local area network (LAN) system or a wireless communication network such as a satellite or cellular telephone communication network or a combination of wired and wireless networks.

In one exemplary embodiment, the mobile telephone (device 114) passes the identification information stored in wireless communication element 112 to the computer network 122 for authentication. The mobile telephone 114 is allowed to access the cellular telephone communication network only if the identification information is verified. In this manner, the wireless service provider may prevent unauthorized access to the network, such as access made by devices that use an unauthorized communication chip set.

In another exemplary embodiment, a user in the supply chain may use a wireless reader device 130 to verify the authenticity of the electronic device 114 before purchasing the device or accepting the device into inventory. In this manner, counterfeit electronic devices may be readily identified when the counterfeit electronic devices fail the verification of the identification information.

In the above described embodiments, identification information stored in the wireless communication device is retrieved either by the IC chips of the MCP module or by a wireless reader device. In other embodiments, information may also be written to and stored in the memory unit of the wireless communication device. For instance, MCP module 110 of Fig. 9 may receive control signals and data from computer network 122 and the designated IC chip of the MCP module may act in response to communicate with wireless communication element 112 to store the received data into the memory unit of the wireless communication element. In other words, the wireless communication element and the designated IC chip implement two-way communication and information may be retrieved from or written to the memory unit of the wireless communication element.

In the above descriptions, the identity or identification information is stored in a memory unit of the wireless communication element or the Pure ID element. In the present description, a memory unit refers to any charge storing device used in integrated circuits, including registers, random access memory, flash memory, volatile or non-volatile memories, or other suitable charge storing devices for storing one or more bits of data.

The above detailed descriptions are provided to illustrate specific embodiments of the present invention and are not intended to be limiting. Numerous modifications and variations within the scope of the claims are possible.

The disclosures in United States patent application number 61/316,822, from which this application claims priority, and in the abstract accompanying this application are incorporated herein by reference.

## Claims

1. A method of providing identity tracking and authentication for a multi-chip package (MCP) module or a designated semiconductor chip selected from one or more semiconductor chips formed on an MCP base of the MCP module, the MCP module being provided with a first communication function, the method including the steps of:
providing a communication element formed on the MCP base, the communication element including a memory unit for storing information including at least identity information of the designated semiconductor chip or the MCP module;
providing an electrical connection between the communication element and the designated semiconductor chip;
accessing by the designated semiconductor chip the information stored in the memory unit of the communication element through the electrical connection; and
providing the information stored in the communication element to a system outside of the MCP module through the first communication function of the MCP module, the information being used at least to track or authenticate the MCP module or the designated semiconductor chip of the MCP module.

2. A method according to claim 1, wherein the MCP base includes a multilayer interconnect substrate and the step of providing an electrical connection between the communication element and the designated semiconductor chip includes:
providing an electrical connection formed on or in the multilayer interconnect substrate between the communication element and the designated semiconductor chip.

3. A method according to claim 1, wherein the step of providing an electrical connection between the communication element and the designated semiconductor chip includes:
providing an electrical connection between the communication element and the designated semiconductor chip using bond wires, solder bumps, gold bumps, conductive pastes, conductive inks or a flexible connector with solder joint bump.

4. A method according to claim 1, 2 or 3, including the steps of:
providing two-way communication through the electrical connection between the communication element and the designated semiconductor chip; and
providing information from the designated semiconductor chip to the communication element to be stored in the memory unit of the communication element.

5. A method according to any preceding claim, wherein the first communication function of the MCP module comprises wireless communication or wired communication.

6. A method according to any preceding claim, including the step of:
generating an identification for the designated semiconductor chip or the MCP module using an algorithm on the communication element or the designated semiconductor chip.

7. A method according to any preceding claim, wherein the information stored in the memory unit of the communication element comprises identity information, part number, model number, model name, brand name, maker, logo design, and original equipment manufacturer (OEM), production and/or distribution history of the MCP module and/or the designated semiconductor chip, the original owner of the microelectronic device or system, wherein the identity information comprises an identity code or an algorithm to generate an identity code in response to interrogations from the one or more semiconductor chips on the MCP base or from a system external to the MCP module.

8. A method according to any preceding claim, including the steps of:
providing a wireless communication circuit to the communication element to form a wireless communication element;
connecting the wireless communication element to an antenna;
accessing the information stored in the memory unit of the wireless communication element through wireless communication with the wireless communication element using a wireless communication device; and
providing the information stored in the memory unit of the wireless communication element to a wired or wireless communication network through the wireless communication device.

9. A method according to claim 8, including the steps of:
forming the antenna on or in the MCP base; and
electrically connecting the antenna to the wireless communication element.

10. A method of providing identity tracking and authentication for a multi-chip package (MCP) module or a designated semiconductor chip selected from one or more semiconductor chips formed on an MCP base of the MCP module, the MCP module being provided with a first communication function, the method including the steps of:
providing a wireless communication element formed on the MCP base, the wireless communication element including a memory unit for storing information including at least identity information of the designated semiconductor chip or the MCP module and including a wireless communication circuit;
providing a wireless communication transceiver formed on the MCP base and in communication with the designated semiconductor chip, the wireless communication transceiver providing a second communication function;
accessing by the wireless communication transceiver the information stored in the memory unit of the wireless communication element through the second communication function; and
providing the information stored in the wireless communication element to a system outside of the MCP module through the first communication function of the MCP module, the information being used at least to track or authenticate the MCP module or the designated semiconductor chip of the MCP module.

11. A multi-chip package (MCP) module including one or more semiconductor chips formed on an MCP base of the MCP module, the MCP module being provided with a first communication function, the MCP module including:
a communication element formed on the MCP base, the communication element including a memory unit for storing information including at least identity information of the designated semiconductor chip or the MCP module; and
an electrical connection between the communication element and a designated semiconductor chip selected from the one or more semiconductor chips formed on an MCP base of the MCP module,
wherein the designated semiconductor chip accesses the information stored in the memory unit of the communication element through the electrical connection, and provides the information stored in the communication element to a system outside of the MCP module through the first communication function of the MCP module, the information being used at least to track or authenticate the MCP module or the designated semiconductor chip of the MCP module.

12. An MCP module according to claim 11, wherein the MCP base includes a multilayer interconnect substrate and the electrical connection is formed on or in the multilayer interconnect substrate.

13. An MCP module according to claim 11 or 12, wherein the electrical connection provides two-way communication between the communication element and the designated semiconductor chip and the designated semiconductor chip provides information to the communication element on the electrical connection to be stored in the memory unit of the communication element.

14. An MCP module according to claim 11, 12 or 13, wherein the communication element includes a wireless communication circuit to form a wireless communication element, the wireless communication being connected to an antenna, and wherein the information stored in the memory unit of the wireless communication element is assessed through wireless communication with the wireless communication element using a wireless communication device.

15. An MCP module according to any one of claims 11 to 14, wherein the MCP base comprises a multilayer interconnect substrate and the antenna is formed on or in the multilayer interconnect substrate.
